**Europäisches Patentamt**

**European Patent Office**

**Office européen des brevets**

(11) Veröffentlichungsnummer: **0 004 341**
B1

(12) # EUROPÄISCHE PATENTSCHRIFT

(45) Veröffentlichungstag der Patentschrift:
23.09.81

(51) Int. Cl.³: **H 03 L 7/08** // H04K1/00

(21) Anmeldenummer: 79100779.2

(22) Anmeldetag: 15.03.79

(54) Synchronisation eines lokalen Oszillators mit einem Referenzoszillator.

(30) Priorität: 17.03.78 DE 2811636

(43) Veröffentlichungstag der Anmeldung:
03.10.79 Patentblatt 79/20

(45) Bekanntmachung des Hinweises auf die Patenterteilung:
23.09.81 Patentblatt 81/38

(84) Benannte Vertragsstaaten:
BE CH DE FR GB IT NL SE

(56) Entgegenhaltungen:
DE-A-1 537 166
DE-A-2 119 091
GB-A-982 327
US-A-3 344 361
US-A-3 694 752
US-A-3 755 748
US-A-3 919 647
ELECTRICAL DESIGN NEWS, Vol. 17
Nr. 6, 15. März 1972,
Denver, US,
JOHNSON: »Low-power digital phase locked
loop utilizes CMOS logic«,
Seiten 36 — 39

(73) Patentinhaber: TE KA DE Felten & Guilleaume
Fernmeldeanlagen GmbH,
Thurn-und-Taxis-Strasse 10 Postfach 4943,
D-8500 Nürnberg 1 (DE)

(72) Erfinder: Robra, Jörg, Dr. Dr.-Ing., Hallerstrasse 7,
D-8501 Heroldsberg (DE)

ELECTRONIC ENGINEERING, Vol. 45,
Nr. 595, August 1977,
London, GB,
SHUM: »Adaptive bandwidth binary digital
phase locked loop«,
Seiten 26, 27

Synchronisation eines lokalen Oszillators mit einem Referenzoszillator

Die Erfindung betrifft die Synchronisation zweier Schwingungen, von denen die eine von einem lokalen Oszillator und die andere von einem Referenzoszillator abgeleitet wird. Der synchrone Verlauf zweier derartiger Schwingungen wird z. B. für eine ordnungsgemäße Verarbeitung von Informationen benötigt, die von einem Sender zu einem Empfänger übertragen werden. In einem solchen Fall handelt es sich bei dem lokalen Oszillator um einen Oszillator auf der Empfängerseite, während mit dem Referenzoszillator ein Oszillator auf der Senderseite gemeint ist. Die übertragene Information enthält weder besondere Synchrorsignale oder ist derart aufgebaut, daß Synchronisiersignale von ihr abgeleitet werden können.

Wird die Übertragung der Information einschließlich der Synchronisiersignale kurzzeitig unterbrochen, so muß der lokale Oszillator mit möglichst konstanter Frequenz unabhängig vom Referenzoszillator weiterschwingen, damit nach der Unterbrechung die Informationsverarbeitung ohne weiteres fortgesetzt werden kann. Besonders empfindlich gegenüber Synchronisationsabweichungen sind z. B. Übertragungssysteme, bei denen die übertragene Information aus verschlüsselter Sprache besteht. Überschreitet der Synchronisationsfehler während der Unterbrechung eine gewisse Grenze, so ist nach der Unterbrechung jede weitere Kommunikation unmöglich, weil der Entschleierungsprozeß auf der Empfängerseite unwirksam wird. Um Synchronisationsfehler möglichst klein zu halten, werden daher quarzgesteuerte Oszillatoren verwendet. Da die Frequenz von Quarzoszillatoren von außen — etwa über spannungsgesteuerte Kapazitätsdioden — nur sehr geringfügig geändert werden kann, jedoch unter Umständen z. B. bei sehr langen Gesprächen über diese Grenze hinaus verändert werden müßte, um Synchronisation mit dem Referenzoszillator zu erreichen, entsteht das Problem, Synchronisation zwischen zwei Schwingungen zu erreichen, von denen die eine von einem Oszillator herrührt, dessen Frequenz durch Eingriffe von außen nicht verändert werden kann oder soll. Ein derartiger Oszillator wird im folgenden Fest-Oszillator genannt.

Eine Lösung des eben erwähnten Problems ist in dem Artikel von D. A. Johnson »Low-power digital phase locked loop utilizes CMOS logic« (Electrical Design News, Vol. 27, Nr. 6, 15. März 1972, Seiten 36—39) beschrieben. In einem aus Halbleiter-Bausteinen aufgebauten Phasen-Regelkreis wird das Ausgangssignal des Fest-Oszillators über einen Teiler mit variablem Teilungsverhältnis geleitet. Abhängig von der Phasenabweichung zwischen dem Ausgangssignal des Teilers und dem Referenzsignal wird über einen Vorwärts-Rückwärts-Zähler und über eine Steuerschaltung das Teilungsverhältnis des Teilers verändert.

Ein anderer Lösungsweg wird in der US-PS 3 919 647 beschritten. Hier enthält der Phasenregelkreis ein nicht näher beschriebenes Stellglied, das — je nach den Werten der zugehörigen Stellgrößen — Impulse im Ausgangssignal des Fest-Oszillators löschen oder hinzufügen sollen. Die Steuerung der Löschung oder Einblendung von Impulsen soll über einen dreistufigen Teiler, einen Codierer und einen Zähler erfolgen.

Ausgehend vom angegebenen Stand der Technik besteht die der Erfindung zugrunde liegende Aufgabe darin, eine aus einfacheren Digitalbausteinen bestehende Schaltungsanordnung anzugeben, mit der die von einem Fest-Oszillator abgeleiteten Schwingungen nach Phase und Frequenz geregelt werden können. Insbesondere soll die Anordnung den Abgriff einer Impulsfolge ermöglichen, deren Impulse nahezu gleichmäßig verteilt sind und deren Impulsfolgefrequenz ein Vielfaches der Frequenz des Referenzsignals beträgt.

Diese Aufgabe wird durch eine Schaltungsanordnung mit den kennzeichnenden Merkmalen des Anspruches 1 gelöst.

Anhand der Figuren wird ein Beispiel für die Erfindung sowie Ausgestaltungen von ihr näher erläutert werden.

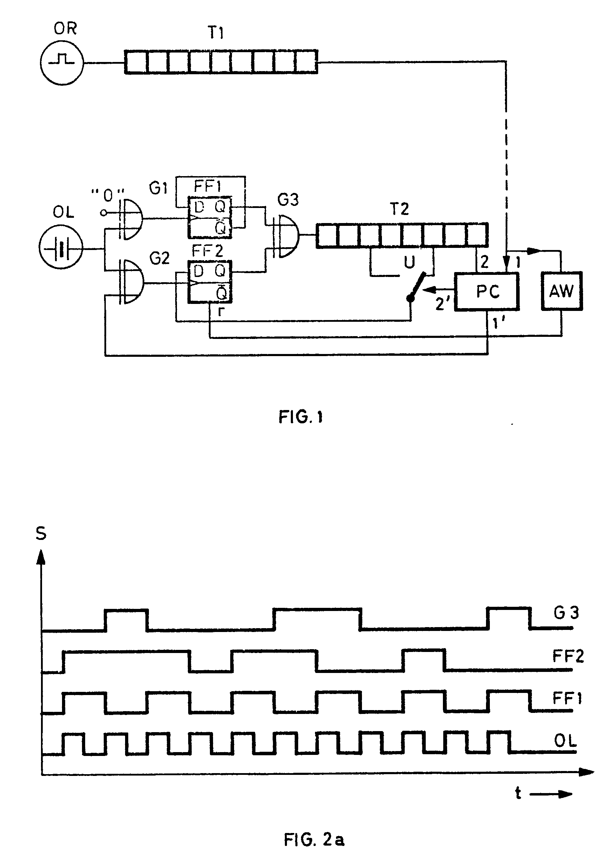

Fig. 1 zeigt in Schaltsymbolen den Fest-Oszillator OL und einen Referenzoszillator OR, von dem die Referenzschwingungen abgeleitet sind. Das Beispiel ist auf den Fall abgestimmt, in dem der Referenzoszillator und der Fest-Oszillator Rechteckschwingungen mit nominell gleicher Frequenz abgeben. Die Schwingungen des Referenzoszillators werden über den N-stufigen Frequenzteiler T1 mit dem Teilungsverhältnis $2^N : 1$ geleitet. Dieser Teiler besteht — wie durch die weitere Beschreibung verständlich gemacht wird — aus mindestens einer Stufe. Die weiteren Stufen des Teilers T1 können dem Zweck dienen, eine über einen bandbegrenzten Kanal übertragbare Referenzschwingung zu erhalten. Nach der Übertragung wird diese Schwingung dem ersten Eingang 1 eines Phasenvergleichers PC zugeführt. An den zweiten Eingang 2 dieses Phasenvergleichers wird — sieht man von Korrekturen ab — die in der Frequenz ebenfalls im Verhältnis $1 : 2^N$ geteilte Schwingung des Fest-Oszillators OL gegeben. Die Teilung erfolgt durch das rückgekoppelte Flip-Flop FF1 und den Teiler T2, der aus $N-1$ Stufen besteht.

Der Phasenvergleicher PC prüft, wie entsprechende Phasen der beiden Eingangssignale — etwa die 50%-Werte der ansteigenden Flanke der Impulse — zeitlich gegeneinander verschoben sind. Bei negativer Phasenzeitdifferenz, d. h., wenn die Phasen der vom lokalen Oszillator abgeleiteten Schwingung hinter den entsprechenden Phasen der Referenzschwingung hinterhereilen, gibt der Phasenvergleicher an seinem Ausgang 1' eine binäre »1« ab. Im umgekehrten Fall, also bei positiver Zeitdifferenz, eine binäre »0«.

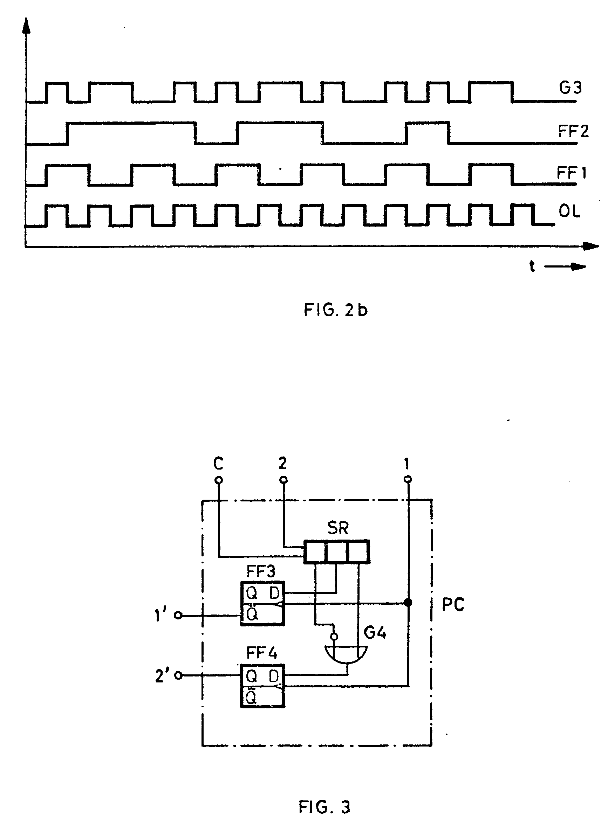

Die Fig. 2a und 2b zeigen Beispiel für binäre Signale S am Ausgang des Oszillators OL, an den Q-Ausgangängen der beiden Flip-Flops FF1 und FF2 und am Ausgang des Gatters G3. Alle Signale sind über der gleichen Zeitachse aufgetragen. Sie sind in den Figuren mit den gleichen Symbolen versehen, wie die Bauteile, an deren Ausgang sie auftreten. In Fig. 2a ist der Fall behandelt, in dem der Phasenvergleicher PC am Ausgang 1' eine »0« abgibt. Nach dem oben Gesagten fallen dann die möglichen Zustandsänderungen des Flip-Flops FF2 mit den Anstiegsflanken des Oszillatorsignales zusammen. Die Modulo-2-Addition der Ausgangssignale der Flip-Flops durch das Gatter G3 führt zu einem Signal, bei dem die Anzahl der Impulse so groß ist, wie die Differenz der Impulszahlen der Einzelsignale. Dem Frequenzteiler T2 wird auf diese Weise eine sogenannte quasi-periodische Schwingung zugeführt, deren Frequenz so groß ist wie die Differenz aus der halben Frequenz des Oszillators OL und der Frequenz der Schwingung, die am Dateneingang des Flip-Flops FF2 anliegt.

In Fig. 2b sind die Verhältnisse für den Fall dargestellt, in dem der Phasenvergleicher am Ausgang 1' eine binäre »1« abgibt. Die Phasenlage der Schwingungen an den Ausgängen der Flip-Flops führt in diesem Falle dazu, daß sich durch das Gatter G3 die Zahl der Impulse der Einzelschwingungen addieren.

Das Ausgangssignal des Gatters G3 ist nun eine quasiperiodische Schwingung, deren Frequenz so groß ist wie die Summe aus der halben Frequenz des Oszillators OL und aus der Frequenz jener Schwingungen, die am Dateneingang des Flip-Flops FF2 anliegt.

Wird z. B. dem Dateneingang des Flip-Flops FF2 das Signal von der k-ten Stufe des Teilers T2 zugeführt, so tritt am Ausgang des Gatters G3 eine quasi-periodische Schwingung auf, deren Frequenz — je nach dem Wert der binären Variablen am Ausgang 1' des Phasenvergleichers PC — im eingeschwungenen Zustand einen der beiden Werte $f/2 \, (1 \pm 2^{-k})$ annimmt, wobei f die Frequenz des Fest-Oszillators OL bezeichnet. Am Ausgang des Teilers T2 kann die Frequenz zwischen den beiden Werten $f/2^N \, (1 \pm 2^{-k})$ pendeln. Liegt die Frequenz der Referenzschwingung zwischen diesen beiden Grenzen, so ist z. B. für $k = 11$ eine relative Frequenzabweichung der Ausgangsschwingung des Teilers und der Referenzschwingung von höchstens 1% möglich. Mit der gleichen Genauigkeit können an jeder Stufe des Teilers T2 Schwingungen abgegriffen werden, deren Frequenz Vielfache der Frequenz der Referenzschwingung sind.

Aus den angegebenen Grenzen, innerhalb derer sich die Frequenz der Schwingung am Ausgang des Gatters G3 oder am Ausgang des Teilers T2 ändern kann, geht hervor, daß eine größere Stufenzahl des Teilers T2 eine genauere Synchronisation mit der Referenzschwingung ermöglicht.

Der Phasenvergleicher PC kann in bekannter Weise aus einem Flip-Flop der schon verwendeten Art bestehen. Um jedoch bei größeren Phasenzeitdifferenzen ein schnelleres Nachregeln zu ermöglichen, ist ein steuerbarer Umschalter U vorgesehen, der beim Überschreiten einer höchst zulässigen Phasenzeitdifferenz den Dateneingang des zweiten Flip-Flops FF2 mit dem Ausgang einer Stufe des Teilers T2 verbindet, an der eine binäre Schwingung mit höherer Frequenz anliegt. Der Umschalter U wird durch einen zweiten Ausgang 2' des Phasenvergleichers PC gesteuert. Tritt z. B. an diesem Ausgang eine binäre »1« auf, so wird die Kontaktstrecke des Umschalters an den Ausgang einer weiter eingangsseitig liegenden Stufe des Teilers T2 geschaltet. Eine mögliche Ausführungsform des Phasenvergleichers für diesen Fall zeigt Fig. 3. Das Schieberegister SR, das im Ausführungsbeispiel aus drei Stufen besteht, ist mit seinem Dateneingang an den Ausgang des Teilers T2 gekoppelt. Die erste Stufe des Schieberegisters SR ist mit dem ersten negierten Eingang des ODER-Gatters G4 und die letzte Stufe des Registers mit dem zweiten nichtnegierten Eingang dieses Gatters verbunden. Der Ausgang des Gatters G4 führt genau dann eine »0«, wenn in der ersten Stufe des Registers eine »1« und in der letzten eine »0« gespeichert ist, d. h., wenn das Schieberegister SR gerade von einer Anstiegflanke durchlaufen wird. Tritt in diesem Augenblick die entsprechende Anstiegflanke des Referenzsignals am Eingang 1 auf, so wird die »0« am Ausgang des Gatters G4 an den Q'-Ausgang des Flip-Flops FF4 übernommen. Da dieser Ausgang mit dem Steuereingang des Umschalters U verbunden ist, unterbleibt damit eine Betätigung des Umschalters. Führt der Ausgang des Gatters G4 eine »1« und tritt dann eine Anstiegflanke im Referenzsignal auf, so beträgt die Phasenzeitdifferenz drei Takte des Taktsignals für das Schieberegister SR. Die an dem Steuereingang des Umschalters U übertragene »1« führt nun zu dessen Betätigung. Das Flip-Flop FF3, dessen Dateneingang mit der mittleren Stufe des Schieberegisters SR verbunden ist und an dessen Takteingang das Referenzsignal anliegt, steuert mit seinem Q-Ausgang das Gatter G2.

Wird die Verbindung zwischen Referenzoszillator und lokalem Oszillator unterbrochen, so sollen die vom lokalen Oszillator abgeleiteten Schwingungen ohne Korrektur verwendet werden. Zu diesem Zweck ist ein Auswerter AW vorgesehen, der beim Ausbleiben der Referenzschwingung an den Rücksetzeingang des Flip-Flops FF2 eine »1« abgibt. Dadurch wird der Q-Ausgang dieses Flip-Flops auf »1« gezwungen bzw. der Q-Ausgang auf »0«. Die vom lokalen Oszillator über das Flip-Flop FF1 kommende Schwingung erfährt nun durch das Gatter G3 keine Änderung.

**Patentansprüche**

1. Schaltungsanordnung zur Synchronisation der Schwingungen, die von einem Fest-Oszillator (OL) abgeleitet sind, mit Referenzschwingungen (OR), die einem Eingang (1) eines Phasenvergleichers (PC) zugeführt werden, während einem anderen Eingang (2) des Phasenvergleichers (PC) das durch ein Stellglied und einen nachgeschalteten Frequenzteiler umgeformte Ausgangssignal des Fest-Oszillators (OL) zugeführt wird und ein Ausgangssignal (1') des Phasenvergleichers (PC) als Stellgröße verwendet wird, dadurch gekennzeichnet, daß der Ausgang des Fest-Oszillators (OL) an einen Eingang eines ersten (G1) und an einen Eingang eines zweiten (G2) EXCLUSIV-ODER-Gatters geführt ist, wobei am zweiten Eingang des ersten Gatters ständig eine binäre »0« anliegt und der zweite Eingang des zweiten Gatters mit einen Ausgang (1') des Phasenvergleichers (PC) verbunden ist und daß die Ausgangsleitung des ersten Gatters zum Takteingang eines ersten rückgekoppelten Flip-Flops (FF1) führt, während die Ausgangsleitung des zweiten Gatters an den Takteingang eines zweiten Flip-Flops (FF2) führt und daß die Q-Ausgänge der beiden Flip-Flops jeweils mit einem Eingang eines dritten EXCLUSIV-ODER-Gatters (G3) verbunden sind und daß der Ausgang dieses Gatters mit dem Eingang des Frequenzteilers (T2) verknüpft ist, wobei ein Ausgang einer Stufe dieses Teilers (T2) an den Dateneingang des zweiten Flip-Flops (FF2) gekoppelt ist.

2. Schaltungsanordnung nach Anspruch 1, dadurch gekennzeichnet, daß ein Ausgang (2') des Phasenvergleichers (PC) mit dem Steuereingang eines steuerbaren Umschalters (U) verbunden ist und daß über die Kontaktstrecke dieses Umschalters der Ausgang einer von zwei verschiedenen Stufen des Frequenzteilers (T2) mit dem Dateneingang des zweiten Flip-Flops (FF2) verbunden ist.

3. Schaltungsanordnung nach Anspruch 2, dadurch gekennzeichnet, daß der Phasenvergleicher (PC) ein dreistufiges Schieberegister (SR), ein drittes und viertes Flip-Flop (FF3, FF4) und ein ODER-Gatter (G4) mit einem negierten Eingang aufweist, daß der Takteingang (C) des Schieberegisters (SR) von einer der ersten Stufen des Frequenzteilers (T2) gespeist wird und daß der Dateneingang des Registers (SR) einen Eingang (2) des Phasenvergleichers (PC) bildet und daß der Ausgang der zweiten Stufe des Registers (SR) an den Dateneingang des dritten Flip-Flops (FF3) führt, während der Ausgang der ersten Stufe mit dem negierten Eingang und der Ausgang der dritten Stufe mit dem nicht negierten Eingang des ODER-Gatters (G4) verbunden ist, dessen Ausgangleitung an den Dateneingang des vierten Flip-Flops (FF4) führt und daß die Takteingänge beider Flip-Flops (FF3, FF4) gemeinsam einen weiteren Eingang (1) des Phasenvergleichers bilden, während der Q-Ausgang des dritten Flip-Flops (FF3) und der Q-Ausgang des vierten Flip-Flops (FF4) zwei Ausgänge (1', 2') des Phasenvergleichers (PC) bilden.

4. Schaltungsanordnung nach Anspruch 1, 2 oder 3 dadurch gekennzeichnet, daß die Leitung für die Referenzschwingungen an den Eingang eines Auswerters (AW) geführt ist, dessen Ausgang eine binäre »1« abgibt, wenn kein Eingangssignal vorhanden ist, und daß der Ausgang des Auswerters (AW) an den Rücksetzeingang (r) des zweiten Flip-Flops (FF2) gekoppelt ist.

**Claims**

1. Circuit for synchronization of the oscillations derived from a fixed oscillator (OL), with reference oscillations (OR) which are connected to one input (1) of a phase comparator (PC), while the output signal of the dixed oscillator (OL), converted by a control element and a subsequent frequency divider, is connected to the other input (2) of the phase comparator (PC) and an output signal (1') of the phase comparator (PC) is used as the control parameter, such that the output of the fixed oscillator (OL) is connected to one input of a first (G1) and one input of a second (G2) EXCLUSIVE OR gate, whereby a binary »0« is continuosly applied to the second input of the first gate and the second input of the second gate ist connected to an output (1') of the phase comparator (PC) and that the output line of the first gate is connected to the clock input of a first flip-flop with internal feedback (FF1), the output line of the second gate is connected to the clock input of a second flip-flop (FF2) and that the Q outputs of the two flip-flops are connected to separate inputs of a third EXCLUSIVE OR gate (G3) and that the output of this gate ist connected to the input of the frequency divider (T2), whereby one output of a stage of this divider (T2) is coupled to the data input of the second flip-flop (FF2).

2. Circuit in accordance with claim 1, such that one output (2') of the phase comparator (PC) is connected to the control input of a controllable changeover switch (U) and that the contact path of this switch connects the output of one of two different stages of the frequency divider (T2) to the data input of the second flip-flop (FF2).

3. Circuit in accordance with claim 2 such that the phase comparator (PC) contains a three-stage shift register (SR), a third and fourth flip-flop (FF3, FF4) and an OR gate (G4) with one inverted input, that the clock input (C) of the shift register (SR) is fed by one of the first stages of the frequency divider (T2), and that the data input of the register (SR) forms one input (2) of the phase comparator (PC), and that the output of the second stage of the register (SR) is connected to the data input of the third flip-flop (FF3), while the output of the first stage is connected to the inverted input and the output of the third stage to the non-inverted input of the OR gate (G4), whose output line leads to the data input of the fourth flip-flop (FF4) and that the clock inputs of both flip-flops (FF3, FF4) together form a further input (1) of the phase comparator, while the Q output of the third flip-flop (FF3) and the $\overline{Q}$ output of the fourth flip-flop (FF4) form two outputs (1', 2') of the phase comparator (PC).

4. Circuit in accordance with claim 1, 2 or 4 such that the line for the reference oscillations is connected to the input of an evaluator (AW) whose output generates a binary »1« if no input signal is present and that the output of the evaluator (AW) is coupled to the reset input (r) of the second flip-flop (FF2).

## Revendications

1. Configuration des circuits pour la synchronisation des oscillations dérivées d'un oscillateur fixe (OL) avec des oscillations de référence (OR) amenées à une entrée (1) d'un phasemètre (PC) tandis que le signal de sortie de l'oscillateur fixe (OL), transformé par un élément de réglage et par un diviseur de fréquence installé en aval, est amené à une autre entrée (2) du phasemètre (PC) qu'un signal de sortie (1') du phasemètre (PC) est utilisé comme granduer de réglage; cela se traduit par le fait que la sortie de l'oscillateur fixe (OL) est amenée à une entrée d'une première porte OU EXCLUSIF (G1) et à une entrée d'une deuxième porte OU EXCLUSIF (G2), un »0« binaire étant appliqué en permanence à la deuxième entrée de la première porte et la deuxième entrée de la deuxième porte étant reliée à une sortie (1') du phasemètre (PC), par le fait que la ligne de sortie de la première porte aboutit à l'entrée de rythme d'un premier flip-flop rétroactif (FF1) tandis que la ligne de sortie de la deuxième porte aboutit à l'entrée de rythme d'un deuxième flip-flop (FF2), par le fait que les sorties Q des deux flip-flop sont reliées respectivement à une entrée d'une troisième porte OU EXCLUSIF (G3) et que la sortie de cette porte est enchaînée à l'entrée du diviseur de fréquence (T2), une sortie d'un étage de ce diviseur (T2) étant couplée avec l'entrée de données du deuxième flip-flop (FF2).

2. Configuration des circuits comme pour 1, se caractérisant par le fait qu'une sortie (2') du phasemeètre (PC) est reliée à l'entrée de commande d'un commutateur contrôlable (U) et que la sortie de l'un de deux étages différents du diviseur de fréquence (T2) est reliée à l'entrée de données du deuxième flip-flop (FF2) par le parcours de contact de ce commutateur.

3. Configuration des circuits comme pour 2, se caractérisant par le fait que le phasemètre (PC) possède un registre à décalage à trois étages (SR), un troisième et un quatrième flip-flop (FF3, FF4) et une porte OU (G4) à entrée NON, que l'entrée de rythme (C) du registre à décalage (SR) est alimentée par un des premiers étages du diviseur de fréquence (T2) et que l'entrée de données du registre (SR) forme une entrée (2) du phasemètre et que la sortie du deuxième étage du registre (SR) aboutit à l'entrée de données du troisième flip-flop (FF3) tandis que la sortie du premier étage est reliée à l'entrée NON et la sortie du troisième étage à l'entrée non complémentaire de la porte OU (G4) dont la ligne de sortie aboutit à l'entrée de données du quatrième flip-flop (FF4), et que les entrées de rythme des deux flip-flop (FF3, FF4) forment ensemble une autre entrée (1) du phasemètre, tandis que la sortie $\overline{Q}$ du troisième flip-flop (FF3) et la sortie Q du quatrième flip-flop (FF4) forment deux sorties (1', 2') du phasemètre (PC).

4. Configuration des circuits comme pour 1, 2 ou 3, se caractérisant par le fait que la ligne por les oscillations de référence aboutit à l'entrée d'un système d'interprétation (AW), dont la sortie fournit un »1« binaire lorsqu'il n'y a pas de signal d'entrée et que la sortie du système d'interprétation (AW) est couplée à l'entrée de remise à zéro (r) du deuxième flip-flop (FF2).

FIG. 1

FIG. 2a

7

FIG. 2 b

FIG. 3